# EUROPEAN PATENT APPLICATION

(11) **EP 2 601 862 A1**
(43) Date of publication of application: **12.06.2013**
(21) Application number: 11192076.5
(22) Date of filing: 06.12.2011
(51) Int. Cl.: A47B 88/14

(54) **Slide assembly**

(71) Applicant: King Slide Works Co., Ltd., Kaohsiung City (TW); King Slide Technology Co., Ltd., Kaohsiung City (TW)
(72) Inventor: Chen, Ken-Ching, Kaohsiung City (TW); Huang, Chien-Li, Kaohsiung City (TW); Wang, Chun-Chiang, Kaohsiung City (TW)
(74) Representative: Viering, Jentschura & Partner

(57) **Abstract**

A slide assembly includes a first rail (10), a second rail (12), a ball bearing unit (14) and a connection unit (16). The first rail (10) has a passage (30) with a stop (32) located at an end thereof. The ball retaining unit (14) has a ball retainer (40) and multiple balls (42) located in the ball retainer (40). The ball retainer (40) is located in the passage (30) and between the first and second rails (10, 12). The ball retainer (40) has an opening (50) which faces the stop (32) of the first rail (10). The connection unit (16) is fixed to the second rail (12) and a cable management arm (18) is detachably connected to an end of the connection unit (16). When the second rail (12) is retracted relative to the first rail (10), the periphery of the opening (50) of the ball retainer (40) contacts the stop (32) and a portion of the balls (42) pass through the stop (32), and the connection unit (16) is located adjacent to the portion of the balls (42) so that the cable management arm (18) is well supported when the slide assembly is in retracted position.

## Description

### FIELD OF THE INVENTION

The present invention relates to a slide assembly, and more particularly, to a slide assembly which is connected with a cable management arm.

### BACKGROUND OF THE INVENTION

The conventional slide assemblies, especially for those slide assemblies with the foldable cable management arms, when the inner rail is slidable relative to the outer rail by balls, the portion between the distal section of the inner rail and the outer rail is often lack of support due to that the balls cannot reach that area. In other words, the distal section of the inner rail is cantilevered and can be easily deformed. When the front side truss of the cable management arm is connected to the distal end of the inner rail, the connection portion between the cable management arm and the distal end of the inner rail is not well supported and the cable management arm is severely lowered.

U.S. Patent Publication No. 2007/0263949 A1 to Chen et al. discloses a "Supporting structure for a slide assembly" which provides a support structure for the slide assembly that is connected to the foldable cable management arm connected with the slide assembly. The slide assembly comprises an inner rail and an outer rail, wherein the inner rail is slidable relative to the outer rail. The inner rail has a ball retainer which is located close to the distal end of the inner rail. The ball retainer has a top groove, a bottom groove and bearings. The inner rail may have a top groove, a bottom groove and bearings. The top and bottom grooves are circulation grooves and each of which has an open section so as to be cooperated with the outer rail. The bearings are received between the top and bottom grooves and located corresponding to the outer rail at the opening sections.

However, there has to be an extra ball retainer so as to support the cable management arm located at the distal section of the inner rail.

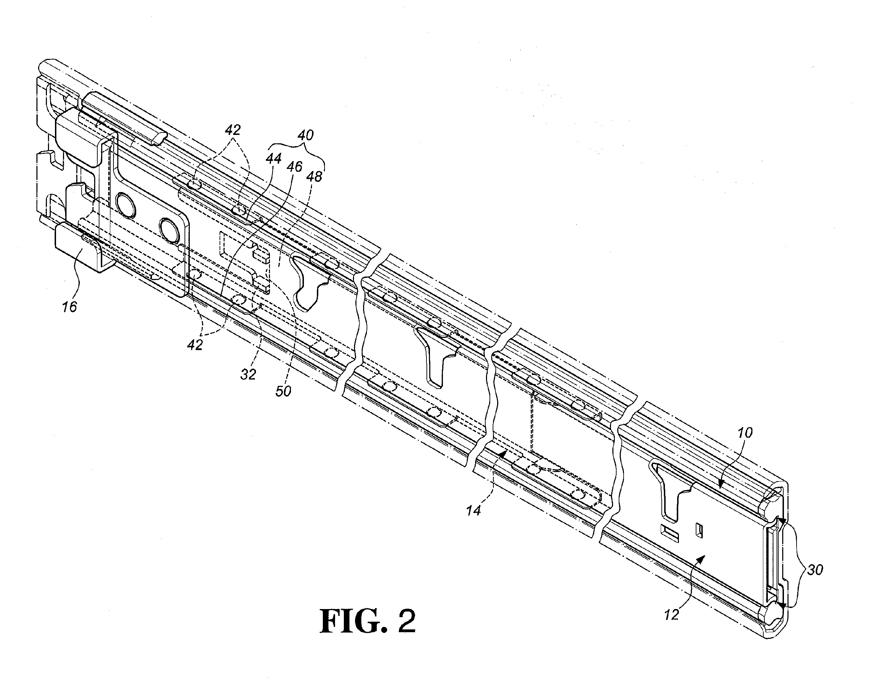

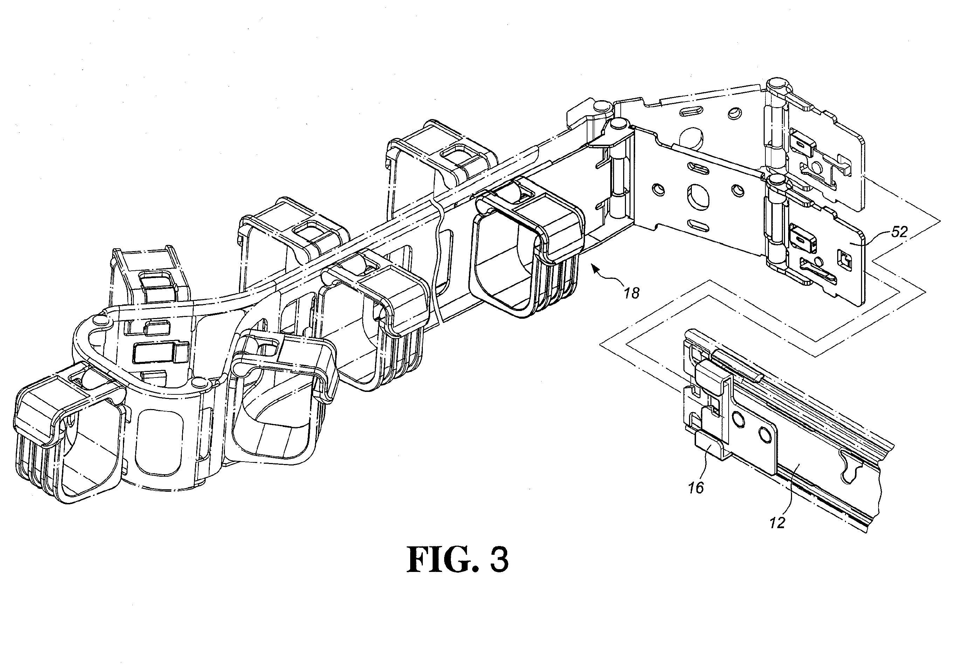

Furthermore, U.S. Patent No. 5,551,775 to Parvin discloses a "Telescopic drawer slide with mechanical sequencing latch", which shows, in Figs. 2 and 3, that there is no balls located at the inner rail close to the distal section.

The present invention intends to provide a slide assembly which provides well support to the distal section of the inner rail to support the cable management arm.

### SUMMARY OF THE INVENTION

The present invention relates to a slide assembly and comprises a first rail having a first top wall, a first bottom wall and a first side wall. The first bottom wall is located corresponding to the first top wall. The first side wall extends between the first top wall and the first bottom wall. The first side wall has a first end and a second end which is located corresponding to the first end. A passage is defined between the first top wall, the first bottom wall and the first side wall. The first side wall has a stop located in the passage and the stop is located adjacent to the first end of the first side wall. A second rail has a second top wall, a second bottom wall and a second side wall. The second bottom wall is located corresponding to the second top wall, and the second side wall extends between the second top wall and the second bottom wall. A ball bearing unit is located in the passage of the first rail and has a ball retainer and multiple balls. The ball retainer has a top retaining portion, a bottom retaining portion and a side portion. The top retaining portion is located adjacent to the first top wall of the first rail. The bottom retaining portion is located adjacent to the first bottom wall of the first rail. The side portion extends between the top retaining portion and the bottom retaining portion. The side portion is located adjacent to the first side wall of the first rail. The balls are located between the top and bottom retaining portions of the ball retainer. The second rail is movable relative to the first rail by the ball bearing unit, and the second rail extends from the second end of the first rail. A connection unit is fixed to the second rail.

The side portion of the ball retainer has an opening which faces the stop of the first rail. When the second rail is retracted relative to the first rail and the connection unit is located adjacent to the first end of the first side wall. A periphery of the opening of the side portion of the ball retainer contacts the stop of the first rail so that a portion of the balls of the ball retainer pass through the stop. The connection unit is located between the stop of the first rail and the first end of the first rail, and the connection unit is located adjacent to the portion of the balls.

Preferably, further comprises a cable management arm detachably connected to one end of the connection unit.

The present invention will become more obvious from the following description when taken in connection with the accompanying drawings which show, for purposes of illustration only, a preferred embodiment in accordance with the present invention.

### BRIEF DESCRIPTION OF THE DRAWINGS

Fig. 1 is an exploded view to show the slide assembly of the present invention;
Fig. 2 shows that the slide assembly is in retracted status;
Fig. 3 shows the position relationship of the slide assembly and the cable management arm, and
Fig. 4 shows that when the slide assembly is in retracted status, the cable management arm is connected to the slide assembly.

### DETAILED DESCRIPTION OF THE PREFERRED EMBODIMENT

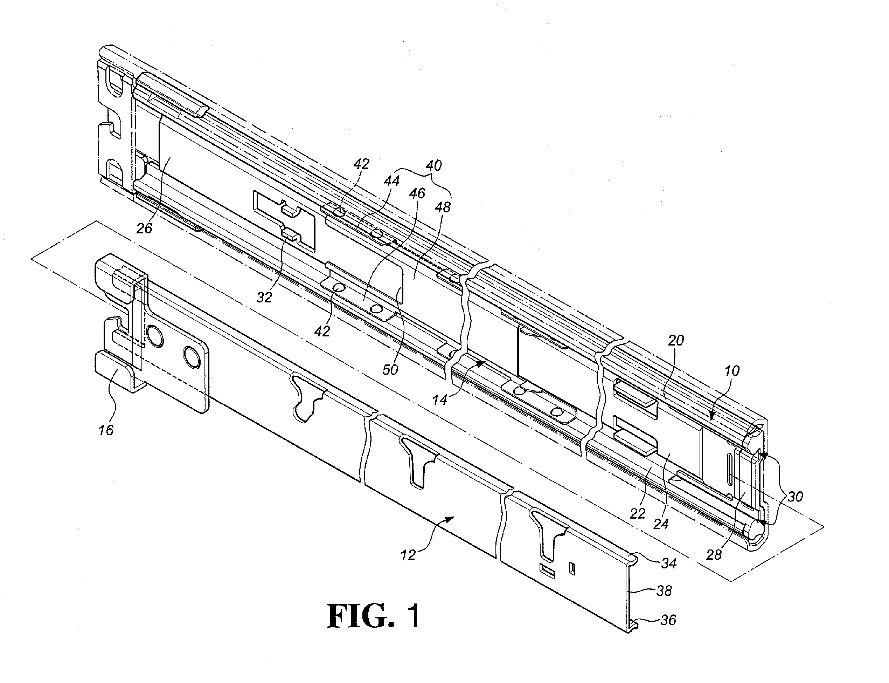

Referring to Figs. 1 and 2, the slide assembly of the present invention comprises a first rail 10, a second rail 12, a ball bearing unit 14 and a connection unit 16. By the slide assembly as mentioned above, a cable management arm 18 is connected to one end of the slide assembly.

The first rail 10 has a first top wall 20, a first bottom wall 22 and a first side wall 24, wherein the first bottom wall 22 is located corresponding to the first top wall 20. The first side wall 24 extends between the first top wall 20 and the first bottom wall 22. The first side wall 24 includes a first end 26 and a second end 28 which is located corresponding to the first end 26. A passage 30 is defined between the first top wall 20, the first bottom wall 22 and the first side wall 24. The first side wall 24 has a stop 32 located in the passage 30 and the stop 32 is located adjacent to the first end 26 of the first side wall 24.

The second rail 12 has a second top wall 34, a second bottom wall 36 and a second side wall 38, wherein the second bottom wall 36 is located corresponding to the second top wall 34. The second side wall 38 extends between the second top wall 34 and the second bottom wall 36.

The ball bearing unit 14 is located in the passage 30 of the first rail 10 and comprises a ball retainer 40 and multiple balls 42. The ball retainer 40 has a top retaining portion 44, a bottom retaining portion 46 and a side portion 48. The top retaining portion 44 is located adjacent to the first top wall 20 of the first rail 10, and the bottom retaining portion 46 is located adjacent to the first bottom wall 22 of the first rail 10. The side portion 48 extends between the top retaining portion 44 and the bottom retaining portion 46. The side portion 48 is located adjacent to the first side wall 24 of the first rail 10. The side portion 48 of the ball retainer 40 has an opening 50 which faces the stop 32 of the first rail 10. The balls 42 are located between the top and bottom retaining portions 44, 46 of the ball retainer 40. When the second rail 12 is pulled out relative to the first rail 10 by the assistance from the ball bearing unit 14, the second rail 12 is pulled along the passage 30 to a position. When the second rail 12 is retracted relative to the first rail 10, the ball bearing unit 14 assists the second rail 12 to be retracted along the passage 30.

The connection unit 16 is fixed to the second rail 12.

The cable management arm 18 is connected to one end of the connection unit 16. Preferably, the cable management arm 18 is detachably connected to one end of the connection unit 16 as shown in Fig. 3. A connection member 52 is connected to the cable management arm 18 at the end that is corresponding to the connection unit 16.

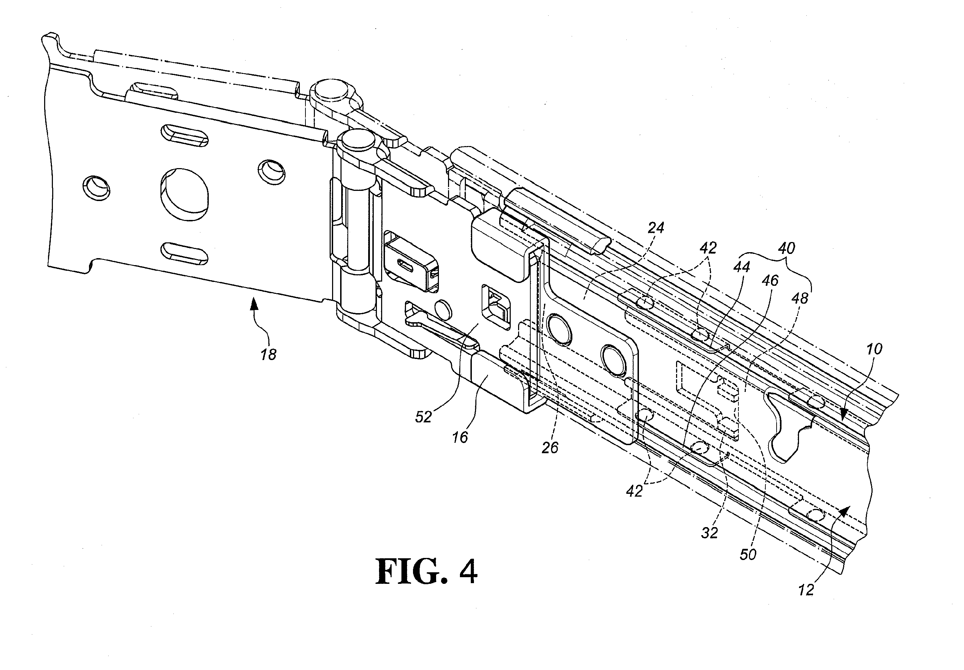

As shown in Fig. 4, when the second rail 12 is retracted relative to the first rail 10 and the connection unit 16 is located adjacent to the first end 26 of the first side wall 24, the periphery of the opening 50 of the side portion 48 of the ball retainer 40 contacts the stop 32 of the first rail 10 so that a portion of the balls 42 of the ball retainer 40 pass through the stop 32, and the connection unit 16 is located between the stop 32 of the first rail 10 and the first end 26 of the first rail 10, and the connection unit 16 is located adjacent to the portion of the balls 42. Therefore, when the cable management arm 18 is fixed to the connection unit 16 by the connection member 52, by the balls 42 that are located between the top and bottom retaining portions 44, 46 of the ball retainer 40 and support the area between the first and second rails 10, 12 and are located adjacent to the connection unit 16, the weight of the cable management arm 18 is applied to the correspondent position of the second rail 12 by the connection member 52 and the connection unit 16. The second rail 12 is not disengaged from the first rail 10, and the cable management arm 18 is not overly lowered. Therefore, the cable management arm 18 is well supported.

In one preferable embodiment, when the second rail 12 is located at the retracted position relative to the first rail 10, the connection unit 16 is located between the first end 26 of the first rail 10 and the stop 32.

While we have shown and described the embodiment in accordance with the present invention, it should be clear to those skilled in the art that further embodiments may be made without departing from the scope of the present invention.

## Claims

1. A slide assembly comprising:
a first rail (10) having a first top wall (20), a first bottom wall (22) and a first side wall (24), the first bottom wall (22) located corresponding to the first top wall (20), the first side wall (24) extending between the first top wall (20) and the first bottom wall (22), the first side wall (24) having a first end (26) and a second end (28) which is located corresponding to the first end (26), a passage (30) defined between the first top wall (20), the first bottom wall (22) and the first side wall (24), the first side wall (24) having a stop (32) located in the passage (30) and the stop (32) located adjacent to the first end (26) of the first side wall (24);
a second rail (12) having a second top wall (34), a second bottom wall (36) and a second side wall (38), the second bottom wall (36) located corresponding to the second top wall (34), the second side wall (38) extending between the second top wall (34) and the second bottom wall (36);
a ball bearing unit (14) located in the passage (30) of the first rail (10) and having a ball retainer (40) and multiple balls (42), the ball retainer (40) having a top retaining portion (44), a bottom retaining portion (46) and a side portion (48), the top retaining portion (44) located adjacent to the first top wall (20) of the first rail (10), the bottom retaining portion (46) located adjacent to the first bottom wall (22) of the first rail (10), the side portion (48) extending between the top retaining portion (44) and the bottom retaining portion (46), the side portion (48) located adjacent to the first side wall (24) of the first rail (10), the balls (42) located between the top and bottom retaining portions (44, 46) of the ball retainer (40), the second rail (12) being movable relative to the first rail (10) by the ball bearing unit (14), the second rail (12) extending from the second end (28) of the first rail (10), and
a connection unit (16) fixed to the second rail (12), **characterized in that**:
the side portion (48) of the ball retainer (40) has an opening (50) which faces the stop (32) of the first rail (10), when the second rail (12) is retracted relative to the first rail (10) and the connection unit (16) is located adjacent to the first end (26) of the first side wall (24), a periphery of the opening (50) of the side portion (48) of the ball retainer (40) contacts the stop (32) of the first rail (10) so that a portion of the balls (42) of the ball retainer (40) pass through the stop (32), the connection unit (16) is located between the stop (32) of the first rail (10) and the first end (26) of the first rail (10), and the connection unit (16) is located adjacent to the portion of the balls (42).

2. The slide assembly as claimed in claim 1, further comprising a cable management arm (18) detachably connected to an end of the connection unit (16).
